# EUROPEAN PATENT APPLICATION

(11) **EP 3 461 242 A1**
(43) Date of publication of application: **27.03.2019**
(21) Application number: 17192615.7
(22) Date of filing: 22.09.2017
(51) Int. Cl.: H05K 3/36

(54) **A MANUFACTURING ARRANGEMENT AND PROCESS FOR ATTACHING CIRCUIT BOARDS AND CONDUCTORS**

(71) Applicant: Halitic SIA, 4701 Valka (LV); Kärkkäinen Investments Oü, 68207 Valga (EE)
(72) Inventor: Kärkkäinen, Tero Kalevi, FI-24800 Halikko (FI)
(74) Representative: LEITZINGER OY

(57) **Abstract**

An object of the invention is a manufacturing arrangement for attaching circuit boards and conductors. The arrangement comprises means for attaching a first part (102) to a second part (104) by means of at least one of adhesive joint, welded joint and soldering joint, means (106) for covering the attachment (101) of the first part (102) and the second part (104) by means of at least one of injection and casting, and the first part (102) is at least one of a circuit board, cable, conductor and wire, and the second part (104) is at least one of a circuit board, cable, conductor and wire.

## Description

### Field of the invention

The present invention relates to attachment techniques of circuit boards and conductors.

### Background of the invention

In prior art manufacturing processes circuit boards are attached by soldering, gluing, welding or by using e.g. spring connectors.

It has been noticed that certain problems exist to fulfill strength requirements of the attachment between the circuit boards according to the prior art and also to fulfill environment requirements. Furthermore prior art embodiments suffer from signal quality problems e.g. so that signals weaken e.g. due to contact disturbances or losses and/or due to aging of the attachment made e.g. by the spring connectors. A drawback is also that prior art embodiments which try to increase strength against mechanical stresses are unable to provide protection especially against moisture.

In prior art document US20080254653 A1 are presented solder attachment embodiments, in prior art document US20140069696 A1 are presented glue attachment embodiments, and in prior art document US8502089 B2 are presented welding attachment embodiments.

### Short description of the invention

An object of the invention is to achieve cost efficient, reliable and compact attachment and practical attachment process to attach two different kinds of circuit boards and/or parts of electrical system. This is achieved by a manufacturing arrangement for attaching circuit boards and conductors. The arrangement comprises means for attaching a first part to a second part by means of at least one of adhesive joint, welded joint and soldering joint, means for covering the attachment of the first part and the second part by means of at least one of injection and casting, and the first part is at least one of a circuit board, cable, conductor and wire, and the second part is at least one of a circuit board, cable, conductor and wire.

The focus of the invention is also a manufacturing process for attaching circuit boards and conductors. In the process is attached a first part to a second part by at least one of adhesive jointing, welded jointing and soldering jointing, is covered the attachment of the first part and the second part by at least one of injecting and casting, and in the method the first part is at least one of a circuit board, cable, conductor and wire, and the second part is at least one of a circuit board, cable, conductor and wire.

The invention is based on attaching of a first part to a second part by at least one of adhesive jointing, welded jointing and soldering jointing, and on covering the attachment of the first part and the second part by at least one of injecting and casting.

A benefit of the invention is that a reliable and cost effective attachment and manufacturing process can be achieved to attach different kinds of circuit boards and/or conductors. The invention also improves signal quality characteristics.

### Short description of the figures

In figure 1 is presented an attachment arrangement between a flexible circuit board and a rigid circuit board according to a first embodiment of the present invention before the attachment is formed.

In figure 2 is presented an attachment arrangement between a flexible circuit board and a rigid circuit board according to a first embodiment of the present invention after the attachment has been made.

In figure 3 is presented an attachment between a flexible circuit board and a rigid circuit board according to a second embodiment of the present invention after the attachment has been made.

### Detailed description of the invention

In the embodiments according to the present invention are improved manufacturing methods of interconnections between circuit boards in order to achieve higher reliability in a novel process in which is integrated component manufacturing techniques to assembly techniques.

In one embodiment according to the present invention is applied a protective capsuling method in a final assembly stage of electronics circuit boards. In the exemplary embodiment a flexible printed circuit board is soldered, welded or glued to a rigid printed circuit board (PCB). The attachment, i.e. joint is protected from mechanical stress and moisture with protective material on and around the attachment area. In addition to improving the mechanical stress strength, this arrangement according to the present invention will improve the long-term reliability of the joint, especially against moisture. The printed circuit board can also be for example a flexible printed cable or a flat flexible connector (FFC).

In one preferred embodiment of the invention a protection from a hardening liquid of multicomponent material is spread over the attachment, e.g. a soldered area, and said material hardens and becomes a strong support for the attachment. By this way tensile and mechanical strength of the joint is substantially increased and the joint will withstand moisture and other environmental stresses. Said material can be hardening material on the basis of heat, UV-radiation and/or time. One, two or three component materials are examples of multicomponent materials according to the invention.

The electrical contact of the attachment according to the invention, especially in the attachment made by welding (e.g. by laser welding or micro welding), is excellent because the PCBs are attached by continuous pure copper. Also, the electrical joint according to the invention, especially in the attachment made by laser welding or micro welding, provides for sophisticated contact properties for high-frequency signals due to very good connection characteristics of the joint (minor or non-existent contact resistance). The mechanical strength of the joint, i.e. the attachment, according to the present invention is high due to protection of the joint according to the invention.

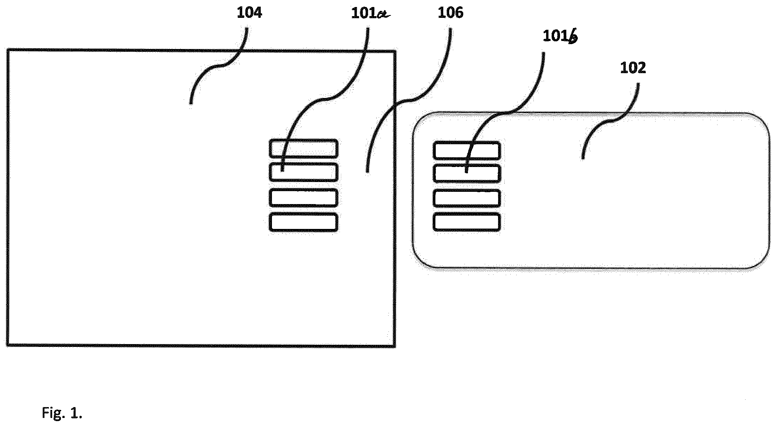

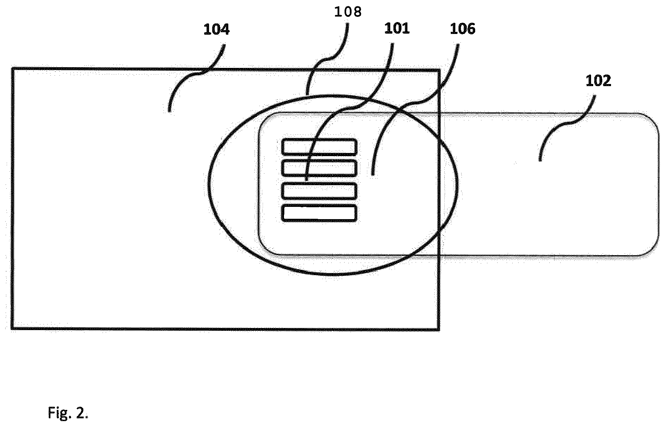

In the following is presented preferred embodiments according to the present invention with a reference to figures 1 and 2. In the manufacturing arrangement according to the present invention can be attached circuit boards and conductors. The arrangement comprises for attaching a first part 102 to a second part 104 by means of at least one of adhesive joint, welded joint and soldering joint. Normally one of said jointing methods is used. Especially the means for attaching a first part 102 to a second part 104 by means of welded joint processes, the attachment provides enhanced electrical contact properties.

The first part 102 can be at least one of a circuit board, cable, conductor and wire, and respectively the second part 104 can be at least one of a circuit board, cable, conductor and wire. In one preferred embodiment according to the present invention the first part 102 is a flexible circuit board, and the second part 104 is a rigid circuit board.

In figure 1 is presented an attachment arrangement between a flexible circuit board and a rigid circuit board according to a first embodiment of the present invention before the attachment 101a, 101b is formed.

In figure 2 is presented an attachment arrangement between a flexible circuit board and a rigid circuit board according to a first embodiment of the present invention after the attachment 101 has been made.

The manufacturing arrangement according to the present invention further comprises means 106 for covering the attachment 101 of the first part 102 and the second part 104 by means of at least one of injection and casting. In one preferred embodiment according to the present invention the means 106 can comprise of hardening liquid, which is hardened over the attachment 101 providing strength and protection to the attachment.

In one embodiment according to the invention the means 106 for covering the attachment 101 of the first part 102 and the second part 104 can comprise tape.

In one preferred embodiment said tape can be e.g. a double-sided adhesive tape in the vicinity of the attachment area between e.g. the flexible printed circuit board 102 and the rigid circuit board 104.

In another embodiment according to the invention the means 106 for covering the attachment 101 of the first part 102 and the second part 104 can comprise adhesive or other binding agent applied to the vicinity of the attachment area between e.g. a flexible printed circuit board 102 and a rigid circuit board 104. The attachment between the circuit boards 102, 104 can be strengthened with an adhesive used in non-electrical attachment areas.

In an embodiment according to the present invention the means 106 for covering the attachment 101 of the first part 102 and the second part 104 can comprise a support part attached onto the attachment area 108. The support part compresses the attachment area against e.g. the rigid circuit board 104. In another embodiment the support part can compress e.g. a PCB, FPC or FFC 102 against a rigid circuit board 104, and the support part operates as a cable clamp.

In one further embodiment according to the present invention the means 106 for covering the attachment 101 of the first part 102 and the second part 104 can comprise a melted plastic mass, which is spread over the attachment area 108, and is hardened onto the attachment area 108.

The manufacturing arrangement according to the invention can comprise fixing means in the flexible circuit board 102, said fixing means being attached onto the rigid circuit board 104. The fixing means can be e.g. handles or brackets designed for a flexible printed circuit board 102, melted
in a suitable way to the rigid circuit board 104. The fixing means can also be e.g. handles or brackets designed for a flexible printed circuit board 102, and screwed by a screw or other mechanical means to the rigid circuit board 104.

The manufacturing arrangement according to the invention can comprise at least one hole being made to the rigid circuit board 104 e.g. by milling, and the flexible circuit board 102 can be attached to the rigid circuit board 104 through said hole.

In one embodiment of the invention electrical contacts can be made along the same direction as the direction of the joint, i.e. attachment. In another embodiment of the invention, the joints between the circuit boards are grouped in several different groups to improve tensile strength. In order to improve coupling characteristics of high frequency signals in an embodiment according to the invention, earth and high frequency signals can be compiled for their own group.

Attachment 101 of the first part 102 and the second part 104 according to the present invention can also be e.g. following: attachment between rigid circuit board 104 and a flat cable 102, attachment between a rigid circuit board 104 and individual conductors 102, attachment between a flexible circuit board 102 and a conductor 104, attachment between individual conductors 102 and conductors 104, attachment between a flat cable 102 and a conductor 104, etc.

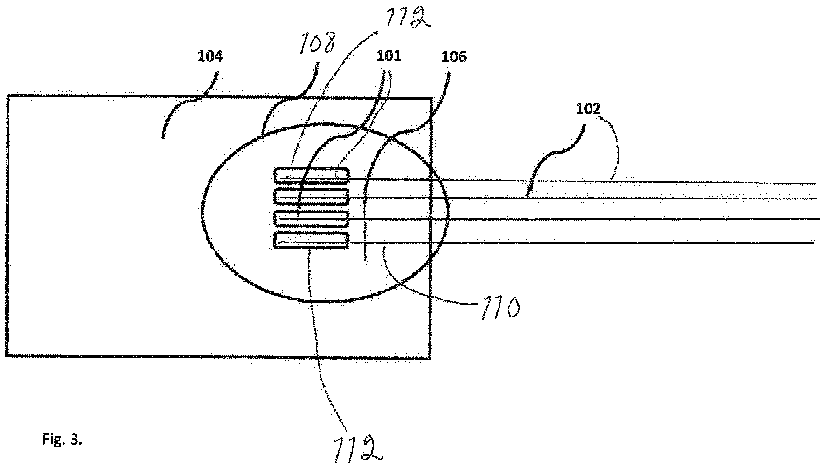

In figure 3 is presented an attachment between a flexible circuit board and a rigid circuit board according to a second embodiment of the present invention after the attachment 101 has been made between wires 110 of the first part 102 and conductors 112 of the second part 104.

The first part according to the present invention can be e.g. a rigid printed circuit board (PCB), and the second part 104 according to the invention can be e.g. a flexible printed circuit board (FCB), flexible printed circuit, flexible printed circuitry (FPC), flat flexible connector, flat flex cable, flexible flat cable, flexible printed cable connector, flexible printed cable and flexible printed circuit interconnecting cable.

In particular for high-frequency and/or high-speed signal applications, the attachments according to the present invention are excellent as the signal path is straight-forward, linear and has less different material components which could distort signals. Signals do not have to pass through internal parts of a connector (e.g. spring contacts of the connector). Signals can couple directly from a rigid circuit board to a flexible circuit board or e.g. to a cable or a wire.

E.g. solder joint or adhesive joint suffers from problems in the signal quality, whereas e.g. a welded copper-copper joint according to the invention has high signal quality characteristics.

The embodiments according to present invention can be utilized e.g. in all applications wherein are utilized flexible circuit boards with their benefits.

Thus, while there have been shown and described and pointed out fundamental novel features of the invention as applied to a preferred embodiment thereof, it will be understood that various omissions and substitutions and changes in the form and details of the invention may be made by those skilled in the art without departing from the spirit of the invention. For example, it is expressly intended that all combinations of those elements which perform substantially the same results are within the scope of the invention. Substitutions of the elements from one described embodiment to another are also fully intended and contemplated. It is also to be understood that the drawings are not necessarily drawn to scale but they are merely conceptual in nature. It is the intention, therefore, to be limited only as indicated by the scope of the claims appended hereto.

## Claims

1. A manufacturing arrangement for attaching circuit boards and conductors, **characterized in that**, the arrangement comprises:
- means for attaching a first part (102) to a second part (104) by means of at least one of adhesive joint, welded joint and soldering joint,
- means (106) for covering the attachment (101) of the first part (102) and the second part (104) by means of at least one of injection and casting,
- and the first part (102) is at least one of a circuit board, cable, conductor and wire, and the second part (104) is at least one of a circuit board, cable, conductor and wire.

2. A manufacturing arrangement according to claim 1, **characterized, in that** the first part (102) is a flexible circuit board, and the second part (104) is a rigid circuit board.

3. A manufacturing arrangement according to claim 1, **characterized, in that** the means (106) for covering the attachment (101) of the first part (102) and the second part (104) comprises of hardening liquid, which is hardened over the attachment (101) providing strength and protection to the attachment.

4. A manufacturing arrangement according to claim 1, **characterized, in that** the means for attaching a first part (102) to a second part (104) by means of at least one of welded joint and soldering joint forms enhanced electrical contact properties.

5. A manufacturing arrangement according to claim 1, **characterized, in that** the means (106) for covering the attachment (101) of the first part (102) and the second part (104) comprises tape.

6. A manufacturing arrangement according to claim 1, **characterized, in that** the means (106) for covering the attachment (101) of the first part (102) and the second part (104) comprises a support part attached onto the attachment area (108).

7. A manufacturing arrangement according to claim 1, **characterized, in that** the means (106) for covering the attachment (101) of the first part (102) and the second part (104) comprises a melted plastic mass, which is spread over the attachment area (108), and is hardened onto the attachment area (108).

8. A manufacturing arrangement according to claim 2, **characterized, in that** the manufacturing arrangement comprises fixing means in the flexible circuit board (102), said fixing means being attached onto the rigid circuit board (104).

9. A manufacturing arrangement according to claim 1, **characterized, in that** the manufacturing arrangement comprises at least one hole being made to the rigid circuit board (104), and the flexible circuit board (102) is being attached to the rigid circuit board (104) through said hole.

10. A manufacturing process for attaching circuit boards and conductors, **characterized in that**, in the process:
- is attached a first part (102) to a second part (104) by at least one of adhesive jointing, welded jointing and soldering jointing,
- is covered the attachment (101) of the first part (102) and the second part (104) by at least one of injecting and casting,
- and in the method the first part (102) is at least one of a circuit board, cable, conductor and wire, and the second part (104) is at least one of a circuit board, cable, conductor and wire.

11. A manufacturing process according to claim 10, **characterized, in that** the first part (102) is a flexible circuit board, and the second part (104) is a rigid circuit board.

12. A manufacturing process according to claim 10, **characterized, in that** in the process is covered the attachment (101) of the first part (102) and the second part (104) by hardening liquid, which is hardened over the attachment (101) providing strength and protection to the attachment.

13. A manufacturing process according to claim 10, **characterized, in that** in the process is attached a first part (102) to a second part (104) by at least one of welded jointing and soldering jointing to form enhanced electrical contact properties.

14. A manufacturing process according to claim 10, **characterized, in that** in the process is covered the attachment (101) of the first part (102) and the second part (104) by taping.

15. A manufacturing process according to claim 10, **characterized, in that** in the process is covered the attachment (101) of the first part (102) and the second part (104) by a support part attached onto the attachment area (108).

16. A manufacturing process according to claim 10, **characterized, in that** in the process is covered the attachment (101) of the first part (102) and the second part (104) by a melted plastic mass, which is spread over the attachment area (108), and is hardened onto the attachment area (108).

17. A manufacturing process according to claim 10, **characterized, in that** in the manufacturing process are processed fixing means to the flexible circuit board (102), and said fixing means are attached onto the rigid circuit board (104).

18. A manufacturing process according to claim 10, **characterized, in that** in the manufacturing process is made at least one hole to the rigid circuit board (104), and the flexible circuit board (102) is attached to the rigid circuit board (104) through said hole.
